(19) Europäisches Patentamt
European Patent Office
Office européen des brevets

(11) EP 4 180 550 B1

(12) EUROPEAN PATENT SPECIFICATION

(45) Date of publication and mention of the grant of the patent:
03.09.2025 Bulletin 2025/36

(21) Application number: 21208007.1

(22) Date of filing: 12.11.2021

(51) International Patent Classification (IPC):
C23C 14/04 (2006.01)    C23C 14/08 (2006.01)
C23C 14/28 (2006.01)

(52) Cooperative Patent Classification (CPC):
C23C 14/042; C23C 14/081; C23C 14/082; C23C 14/28

(54) **MASK-ASSISTED RADIALLY SEGMENTED TARGET PHYSICAL VAPOR DEPOSITION**

MASKENGESTÜTZTE PHYSIKALISCHE GASPHASENABSCHEIDUNG MIT RADIALEM SEGMENTIERTEM ZIEL

DÉPÔT PHYSIQUE EN PHASE VAPEUR DE CIBLES RADIALEMENT SEGMENTÉES ASSISTÉ PAR MASQUE

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR

(43) Date of publication of application:
17.05.2023 Bulletin 2023/20

(73) Proprietor: Universität Leipzig
04109 Leipzig (DE)

(72) Inventors:
• Wenckstern, Holger von
04109 Leipzig (DE)
• Kneiß, Max
04109 Leipzig (DE)
• Splith, Daniel Thomas
04109 Leipzig (DE)
• Grundmann, Marius
04109 Leipzig (DE)

(74) Representative: Hertin und Partner
Rechts- und Patentanwälte PartG mbB
Kurfürstendamm 63
10707 Berlin (DE)

(56) References cited:
US-A- 6 045 671        US-A1- 2012 122 317
US-A1- 2015 030 759

• VON WENCKSTERN HOLGER ET AL: "A Review of the Segmented-Target Approach to Combinatorial Material Synthesis by Pulsed-Laser Deposition", vol. 257, no. 7, 1 July 2020 (2020-07-01), DE, pages 1900626, XP055907219, ISSN: 0370-1972, Retrieved from the Internet <URL:https://onlinelibrary.wiley.com/doi/full-xml/10.1002/pssb.201900626> DOI: 10.1002/pssb.201900626
• ZHANG ZHIPENG ET AL: "Wavelength-selective ultraviolet (Mg,Zn)O photodiodes: Tuning of parallel composition gradients with oxygen pressure", APPLIED PHYSICS LETTERS, AMERICAN INSTITUTE OF PHYSICS, 2 HUNTINGTON QUADRANGLE, MELVILLE, NY 11747, vol. 108, no. 24, 13 June 2016 (2016-06-13), XP012208589, ISSN: 0003-6951, [retrieved on 19010101], DOI: 10.1063/1.4954375

## Description

In a first aspect, the invention relates to a method of producing a thin film material composition on a substrate with a desired material distribution comprising providing an ablation source, the substrate and a target comprising target material which is inhomogeneous and to be deposited onto the substrate, wherein the ablation source is emitting an ablation beam onto the target along an ablation track by means of the ablation source, such that the target material is ablated and deposited on the substrate forming the thin film material composition. The target comprises at least two segments having different chemical compositions. The chemical composition of the material flux of target material towards the substrate is defined by a composition of the target material by an average composition of target material along the ablation track. The method is characterized in that the ablation track repeatedly covers the at least two segments such that the ablation track defines the average chemical composition of the material flux of the target material towards the substrate and a mask comprising at least one aperture is located between the target and the substrate, wherein the mask and the substrate are presently positioned moveable with respect to each other allowing for selectively depositing the chemical composition of the material flux of target material on the substrate to yield the desired material distribution.

In further aspects, the invention refers the use of the process according to the invention to produce a thin film material composition.

Background and state of the art

Thin-film technology deals with the production and processing of thin layers of different materials, such as metallic, dielectric and/or semiconducting materials. The thickness of such layers is typically in the range of a few micrometres to a few nanometres.

The layers are usually deposited two-dimensionally on a substrate by a coating process. Subsequently, further processing of the layers can take place, including post-treatments such as doping or targeted material removal from the layer. Preferably, the layers may be further structured after coating, i.e. the layer material may be specifically removed in certain areas of the substrate. There are a variety of techniques for structuring a post-treatment, which may be of particular use for products of semiconductor electronics, such as integrated circuits, thin-film solar cells and/or microsystems technology, such as sensors or actuators.

Thin film technology conveys several benefits associated with their low thickness, high material economy and ever-improving techniques for large-scale mass production. Thin-film technology can be used to produce micro technical components or other functional layers using various processes. The small dimensions of thin films make in this regard the use of expensive materials economical and allow for a high performance of the resulting products.

In the prior art, various possibilities and applications are known for depositing thin films on a substrate.

Jilani et al. (2017) summarizes different methods of the state of the art to obtain thin films on a substrate. A distinction is made between physical and chemical deposition processes. Chemical deposition processes include methods such as sol-gel deposition, chemical vapor deposition and chemical vapor deposition processes such as LPCVD (low pressure chemical vapor deposition), PECVD (plasma enhanced chemical vapor deposition) and ALD (atomic layer deposition). Physical deposition processes include in particular evaporation techniques and sputtering techniques. The evaporation techniques of physical deposition processes include, for example, thermal vacuum evaporation, electron beam evaporation and laser deposition while the sputtering techniques include DC- and RF-sputtering. In DC-sputtering (direct current), a DC voltage is applied between a target and the substrate to be coated. In RF-sputtering (radio frequency), an AC voltage is applied.

From the prior art it is known to obtain continuous composition spreads (shorted CCS) by physical deposition processes. CCS are typically characterized by thin films with gradients in their composition.

Coatings that used multiple targets for deposition were investigated early on. In Miller and George (1967) $SiO_2$ thin-film cermet's have been deposited by simultaneously DC-sputtering Aluminium and RF-sputtering $SiO_2$.

In prior art, it is also known to obtain continuous material compositions by laser deposition, in particular pulsed laser deposition using pulsed laser beams.

Sakai et al. (2020) proposes to provide two targets that are evaporated by laser beams. The targets are separated from each other by a partition and allow for the formation of a desired lateral material composition on the substrate.

It is however also known to use pulsed laser deposition to obtain a desired composition distribution using a single segmented target.

Von Wenckstern et al. (2013) discloses a CCS-PLD method for forming lateral gradients, wherein the target is segmented into two or more segments (e.g. circular segments) having different material compositions. Herein, a synchronous rotation of target and substrate takes place, while the ablation is performed in each of the segments. Thereby a lateral material gradient between resulting composition segments on the substrate may be created. The resulting lateral material gradient depends not only on the distance between target and substrate and the background pressure, but also on the composition and thus also on the segmentation of the target and the so-called offset, which describes the lateral distance between the point of impact of a laser beam on the target and the centre of the substrate. It is difficult however to obtain material gradients with a pronounced steepness.

Kneiß et al. (2018) discloses a VCCS-PLD method for providing a vertical material gradient that uses radially segmented targets. For example, the targets have inner and outer segments with different chemical compositions. The target rotates while the pulsed laser beams impinges on the target forming an ablation track which covers both inner and outer segments. Altering the ratio of the path length of the ablation track sweeping over either one of the target allows for selecting an average chemical composition of the plasma plume that reaches the substrate. Thereby, different chemical compositions may be deposited onto the substrate to form a vertical gradient of a material composition on the target.

Both methods are also summarized in von Wenckstern et al. (2020). Thus, both the CCS-PLD method and the VCCS-PLD method are described in it. In Wenckstern et al. (2020) it is concluded that movable masks are not required to obtain a desired material distribution on a substrate.

US 2012/0122317 A1 discloses a device for pulsed laser deposition of target material onto a substrate. The substrate onto which the deposition is performed is arranged on a substrate mount. Starting from a target mount, a plasma lobe propagates towards the substrate. The target mount can be attached to arms of a rotatable frame. The shadow masks are located on a disc, which is located between the target mounts and the substrate. On the disc openings are present over which the shadows masks are positioned to obtain a desired configuration of the openings through which the coating on the substrate is to take place. No lateral variations between the disc and the substrate are possible.

US 2015/0030759 A1 relates to a method for depositing a material on a substrate. Starting from an excimer laser, radiation is emitted which is guided by beam splitters and a mirror towards optics comprising spherical lenses. In an embodiment, a beam is incident on each of targets arranged on a target holder and a plate holder. Furthermore, a laser beam block is used, which comprises a hole and can sequentially pass the radiation to the respective target. Starting from the targets, a plume propagates towards the substrate. A mask with apertures is provided on the substrate.

US 6 045 671 relates to physical masking systems and methods for applying films of material to a substrate with different depositions techniques, including sputtering, laser deposition, ion beam, electron beam and thermal evaporation or spray coating. In one embodiment a laser deposition system is disclosed which includes a movable container holder or target wheel (e.g., a wheel, polygon, disc, or other configurations) designed to rotate target materials in and out of the laser beam's path rapidly (typically within one second to several minutes). The target wheel is usually capable of holding multiple target materials, preferably eight or more. After the laser irradiates the first target material, the target wheel can be quickly rotated to bring a second target material into position for irradiation. If the target wheel is moving quickly, the vapors from the first and second target materials may mix before being deposited onto the substrate. The laser system also incorporates shutter masks to control the deposition of the irradiated target materials onto the substrate. Segmented targets are suggested in US 6 045 671 in relation to magnetron sputtering, but not for pulsed laser deposition. In light of the methods of the prior art there is a need for providing improved methods, which allow for an improved control over the local chemical composition of the thin film on very small scales, especially in the sub-mm range. In particular given the current methods it is not possible to place a relatively large amount of a material selectively in a small spatial region of a substrate as it would be desirably to produce steep material gradients. The reproducibility of material distributions on a substrate is a further issue in methods of the prior art, for which alternative solutions are thus desirable.

Objective of the invention

The objective of the present invention was to eliminate the disadvantages of the prior art and to provide an improved coating process. In particular, it was an objective of the invention to provide a flexible, but reproducible process with which a desired material composition of a thin layer on a substrate can be formed with high precision, wherein the material composition may preferably include lateral and/or vertical gradients with a higher steepness compared to methods of the prior art.

Summary of the invention

The objective according to the invention is solved by the features of the independent claims 1 and 12. Advantageous embodiments of the invention are described in the dependent claims.

The invention refers to a method of producing a thin film material composition with a desired material distribution on a substrate comprising

a) providing an ablation source, the substrate and a target comprising target material which is inhomogeneous and to be deposited onto the substrate, the inhomogeneous target comprises at least two segments, the segments having different chemical compositions,

b) emitting an ablation beam onto the target along an ablation track by means of the ablation source, such that the target material is ablated and deposited on the substrate forming the thin film material composition, wherein a chemical composition of a material flux of target material towards the substrate is defined by an average composition of target material along the ablation track

characterized in that

the ablation track repeatedly covers said at least two segments such that the ablation track defines the average chemical composition of the material flux of the target material towards the substrate and a mask comprising at least one aperture is located between the target and the substrate, wherein the mask and the substrate are presently positioned moveable with respect to each other allowing for selectively depositing the chemical composition of the material flux of target material on the substrate to yield the desired material distribution.

The process according to the invention offers advantages in many aspects as it will become apparent in the following description.

As one advantage the process according to the invention allows for the local chemical composition of a thin film with improved precision and on particular small scales. Herein, the phrase "small scales" refers preferably to the mm (millimeter) range, preferably sub-mm range, i.e. a range of less than about 1 mm.

In this regard the method according to the invention advantageously allows a specific chemical composition of a material distribution to be specifically placed on a desired small spatial area of the substrate. Advantageously, to this end the method allows for a direct and reproducible control over the chemical composition of the material flux at predetermined substrate positions independently of the offered material flux at other substrate positions and independent of the reactor geometry wherein the coating takes place. Such independent control has typically not been possible with methods known in the prior art, since a desired material distribution on the substrate is either applied over too large areas on the substrate or the reactor geometry (e.g. geometric arrangement between the ablation source, the target, the mask and/or the substrate) limits possible material compositions to be deposited, in particular in regards to the steepness of the gradients achievable.

The invention improves upon known methods for depositing a desired chemical composition of a material distribution on a substrate by decoupling the control of the chemical composition of the material flux from the substrate position onto which the material flux is to be deposited to form a material distribution. Instead, the chemical composition of the material flux at any position on the substrate is thus controlled independently of the composition at other substrate positions.

Technically, this is achieved in particular by providing a mask comprising at least one aperture between the target and the substrate in the method according to the invention, wherein the mask and the substrate are presently positioned moveable with respect to each other. Herein, the at least one aperture of the mask thus allows for a selective deposition of the material flux provided by the ablated target to desired positions on the substrate.

Advantageously, the method according to the invention allows for obtaining a variety of material distributions on the substrate. For example, a desired material distribution in the growth direction can be obtained. Furthermore, the method according to the invention allows a homogeneous material distribution to be applied to a desired (small) location of the substrate and/or substantially over the entire surface along the substrate. It is also possible that a desired lateral material distribution is obtained with a varying composition to provide a material gradient. Furthermore, the method according to the invention allows for obtaining arbitrary patterns and/or structures of material distributions on the substrate, such as structures or patterns of lateral, vertical or combined material gradients.

The inventors have realized that using a mask in the context of the claimed method for producing a thin film material conveys the aforementioned beneficial effects. Such a teaching was not obvious for a person skilled in the art, especially given the notion in the field that using a mask for producing a thin film material composition on a substrate considerably reduces the growth rate of the coating. Instead, the aim for the growth rate used to be as high as possible for state of the art deposition methods (such as CCS). The inventors have however realized that in the context of forming thin-film material distributions on a substrate - such as a vertical or lateral material gradient - the substantially improved precision by using a mask outweighs a possible reduction in growth rate by far.

Preferred embodiments for obtaining a variety of possible material distributions on the substrate will be detailed in the following paragraphs.

According to the invention, a desired composition of the material flux (prior to the mask) is obtained by ablating the target using the ablation source at a specific ablation point and/or along an ablation track. The material with which the thin film is to be created on the substrate thus originates from said target. The ablation source preferably corresponds to a source for providing energy or heat (e.g. a photon, ion beam etc.) to break the atomic and/or molecular bonds of the target material. For example, a laser or an ion source may be employed as an ablation source, which transfers energy to the target via an ablation beam, such that the target material is converted into plasma or in a gaseous state at the point of ablation. In the state of the art, the terms plasma plume or plasma lobe are common in this context and refer to the flux of plasma towards the substrate onto which the material is deposited. As used herein, the term plasma preferably refers to such a plasma plume or lobe. When the target changes to the gaseous state at the ablation point, gas particles move towards the substrate and the propagating particles may be denoted as a gas plume or lobe. The person skilled in the art recognises that the technical effects and advantages associated with the flux of target material towards the substrate as a plasma (plume), equally apply to a flux of target material as a gas (plume), unless noted otherwise.

The propagation direction of the generated gas or plasma (plume) is preferably perpendicular to the target surface and in direction to the surface of the substrate. In the gas or plasma (plume) the chemical composition or stoichiometry of the elements is governed by the chemical composition or stoichiometry of elements of the target at the ablation point and/or along the ablation track. Without presence of a mask, the target material composition of the gas or plasma (plume) would be deposited homogenously on the surface of the substrate. Providing a mask with at least one aperture allows for a selective deposition of said material onto the substrate.

In the context of the invention, the "mask" preferably relates to an object that serves to spatially limit the material flux of the plasma (plume) propagating from the target onto the substrate. For this purpose, the mask is generally suited for blocking the propagating plasma of target material but comprises at least one aperture selectively allowing the passage of the material flux of target material. The target material to be deposited hence reaches the substrate only through the aperture of said mask, such that only corresponding unshadowed areas of the substrate are selectively coated.

A desired chemical composition of the material flux in the gas or plasma plume can be achieved in several ways with the target or target material having inhomogeneity with respect to their chemical composition. Inhomogeneity with respect to chemical composition preferably means that the target exhibits areas that are characterized by distinct (different) chemical compositions. Chemical composition may refer to proportions of the elements, compounds and/or alloys forming the target material. By choosing a position of the ablation point on the target the chemical composition of the material flux of the forming plasma corresponds to the chemical composition of target material at said ablation point. While the ablation beam dwells on a given ablation point on the target, a chemical composition corresponding to the target material composition on the target at said ablation point may thus be deposited onto the substrate. Changing the ablation point on the target allows for selecting a different chemical composition to be deposited on the substrate.

Preferably the mask allows for a selective positioning of said chemical composition to form a desired material distribution on the substrate. Advantageously in this regard using the mask for depositing a desired chemical composition at a certain position onto the substrate can be decoupled from the material distribution presented by the target.

For instance, the target may comprise a lateral gradient for a differing chemical composition. By keeping the relative position of the mask - and thus the aperture fixed - regarding the substrate, while successively moving the ablation point along the lateral gradient of target material, a vertical gradient of target material may be deposited onto the substrate at a point corresponding to the position of the aperture. The course (e.g. steepness) of the vertical gradient of the material deposited on the substrate may be adjusted based on the dwell time of the ablation beam at the different positions on the target.

Likewise, a lateral gradient of a material composition presented by the target may be transferred on the substrate by simultaneously moving the mask - and thus the aperture - along a lateral line over the substrate, while the ablation point is moved along the lateral gradient on the target.

Arbitrary patterns or combinations of lateral and/or vertical gradients are conceivable. While the ablation point on the inhomogeneous target selects a certain chemical composition for the (plasma) material flux towards the substrate, the movable mask and/or substrate allows for generating a desired material distribution on the substrate.

Selecting a desired chemical composition for a certain area on the substrate by ablating the target material at a fixed ablation point limits however the chemical compositions that can be deposited to the substrate to a material composition presented by the target at least at one position (ablation point).

In order to achieve for instance a lateral gradient of a material composition on the substrate, the different chemical compositions that make up the gradient will have to be present in the inhomogeneous target. This requirement adds to the complexity for providing the target.

In a particular preferred embodiment a chemical composition of a material flux of target material towards the substrate - which may be selectively deposited onto the substrate by the mask comprising at least one aperture - may be defined by the average composition of target material along an ablation track.

For instance, the target may be composed of two segments with differing chemical compositions. One of the segments may for instance have a composition of the form $A_xB_{1-x}$ and the second segment may have a composition of the form $A_yB_{1-y}$, where the indices x and y may take values between 0 and 1 and A and B may be elements, compounds and/or alloys. By moving the ablation beam on the target along an ablation track that covers both segments the composition of the material flux of plasma moving toward the substrate correspondingly changes constantly between $A_xB_{1-x}$ and $A_yB_{1-y}$. The temporal average of the material flux composition is given by the respective path length through the first or second segment. By repeatedly sweeping over the segments - e.g. using a circle or an ellipse for an ablation track - an averaged chemical composition of the material flux in the plasma is achieved, which directly relates to the average path length of the ablation track in the first or second segment. Altering the ablation track to alter the ratio of path lengths in the respective segments advantageously allows for selecting a desired averaged chemical composition $A_\alpha B_{1-\alpha}$, with $\alpha$ depending on the ablation track taking any value between x and y.

Advantageously, in this embodiment the target itself does not have to comprise the desired chemical composition (e.g. $A_\alpha B_{1-\alpha}$) in order for it to be deposited onto the substrate. Instead, the target may be provided with only two segments, wherein the choice of an ablation track allows for generating a desired averaged chemical composition to be deposited onto the substrate.

Also, in this case advantageously providing a movable mask and/or substrate allows for generating an arbitrary desired material distribution on the substrate with unprecedented precision. To this end by selecting a certain ablation track over the inhomogeneous target an average chemical deposition to be deposited is selected, wherein the relative positioning of mask and substrate determines at which point on the substrate said average chemical deposition is deposited. In case the ablation track corresponds to a repetitive ablation track crossing the segments multiple times, the dwell time preferably covers at least one repetition, preferably a plurality of repetitions.

Thus, a selective adjustment of the chemical distribution to be deposited on the substrate results from the impingement of the ablation source on the target wherein the relative movement between the mask and the substrate allows for precisely selecting the deposition location on the substrate. A number of material compositions are conceivable.

A lateral homogeneous material distribution on the substrate can be achieved by repeating a given ablation track on the target, while a lateral relative movement between the mask and the substrate is performed. Advantageously, a homogeneous material distribution can be deposited very precisely and accurately on a desired (small) (sub-)area of the substrate. A lateral homogeneous material distribution can be obtained by lateral relative movement between the substrate and the mask with a given ablation track repeated for different relative positions of mask and substrate. A vertical homogeneous material distribution can be obtained by a fixed ablation track without a relative movement between the substrate and the mask. A fixed ablation track preferably means an ablation track whose geometric shape and/or dimensions are not changed for a desired coating duration at a given relative substrate and mask position.

An inhomogeneous material distribution along the growth direction for certain areas on the substrate can be achieved by varying the ablation track for different fixed lateral positions of a mask with suitable aperture in respect to the substrate.

For example, a target with an inner and an outer segment with different chemical compositions may be provided, wherein an average chemical composition of the gas or plasma plume can be determined by the respective path length of the ablation track on the inner or outer segment. Preferably the ablation track may be a circle, e.g. using a rotating target. By varying the distance radius of the ablation track, the respective path lengths in the inner and outer segment and thus the average chemical composition may be altered.

To achieve a lateral inhomogeneous material distribution, for example in form of a lateral material gradient, a relative movement between the mask and the substrate, while varying the ablation track may be performed. For example, for a certain time the mask with the at least one aperture can be located over a first point of the substrate to obtain a desired first material composition at this point (as determined by a first ablation track, e.g. with a first radius). The mask and/or substrate may be subsequently moved such that the aperture ensures deposition of a desired second material composition (as determined by a second ablation track, e.g. with a second radius) at a second point on the substrate. Advantageously, the provision of a chemical material deposition (by altering the ablation track on a segmented target) and their location of deposition on the substrate (depending on the relative position of mask with at least one aperture and the substrate) may be independently controlled to provide for particularly steep material gradients.

A vertical inhomogeneous material distribution, in particular a vertical material gradient, can be achieved on the substrate by changing the ablation track and keeping a fixed position between the mask and substrate.

Advantageously, given the method according to the invention any conceivable combination of lateral and vertical material distributions can be achieved. To this end, the method according to the invention allows independent control of the chemical composition of the material flux, in particular of the gas or plasma plume, and the position on the substrate on which it is to deposited. This is achieved by decoupling the chemical composition of the flux from the position on the substrate on which it is to deposit. The chemical composition of the plasma is formed by the ablation point or the ablation track on the target. The selectable position of the corresponding chemical composition is determined by the mask, in particular by a relative movement of the mask and the substrate.

Advantageously, this makes it possible to obtain any 0-, 1-, 2- and/or 3-dimensional material distributions, structures and/or patterns on the substrate that have a desired chemical composition.

It is furthermore also possible to place multiple structures on a single substrate, especially if the mask has multiple apertures. This may additionally shorten process steps and be of particular interest for high replication numbers of desired structures in mass production.

For the purposes of the invention, a "substrate" relates preferably to material carrier, preferably in the form of a planar disc with a thickness in the millimeter or submillimeter range, e.g. a circular disk. Substrates generally serve as material carriers for, for example, coatings or components, in particular semiconductor devices, MEMS (micro electrical mechanical components) devices and/or electronic circuits. The use of the term wafer instead of substrate is also known in the prior art. In particular, structures of semiconductor technology and/or microsystem technology can be placed on the substrate by the process according to the invention.

The substrate may include materials selected from the group consisting of monocrystalline silicon, polysilicon, silicon dioxide, silicon carbide, silicon germanium, silicon nitride, germanium, carbons, gallium arsenide, gallium nitride, indium phosphide, gallium oxide, sapphire, strontium titanate, gallium phosphide, aluminium, aluminium oxide, corundum, and/or glass. These materials are particularly easy and inexpensive to process in semiconductor and/or microsystem technology and are also well suited for mass production.

In preferred embodiments the substrate may be operatively connected to a heating element in order to provide a desired homogeneous heat distribution. The term "operatively connected" here means that the heating element transfers thermal energy to the substrate. The heating element may be directly connected to the substrate, for example on an underside, where in the present case the underside means the side of the substrate that is not coated with the target material. It may also be preferred that the heating element is not directly connected to the substrate but, for example, via a heat conductor. A homogeneous heat distribution found on the substrate is advantageous in that the target material, which according to the invention is in the form of a plasma or a gaseous state, can be coated onto the substrate particularly well and forms a stable, robust and reliable bond with the surface of the substrate. In further embodiments, the substrate may be displaced via, for example, an actuator to provide relative movement between the mask and the substrate. The average skilled person knows that a number of devices can be used to heat the substrate to a desired temperature, which may also include laser heaters, which do not have to be in direct contact with the substrate to achieve a desired temperature.

In the sense of the invention, the "target" preferably refers to a target body that is impinged by the ablation source and whose material, the target material, is to be deposited on the substrate. The target may be composed for instance of powders of various elements, compounds and/or alloys for providing an inhomogeneous target comprising differing chemical compositions. Different possibilities for preparing the target are known to the person skilled in the art and disclosed, for example, in von Wenckstern et al. (2020).

In the context of the invention, the term "inhomogeneous target" preferably refers to an inhomogeneous chemical composition of the target material. Herein, different areas of the target preferably are characterized by distinct chemical compositions. Chemical composition may refer to proportions of the elements, compounds and/or alloys forming the target material. For example, the target may include two or more regions or segments that have different proportions in their atomic species, elements, compounds, and/or alloys A and B. For example, one region may have a composition of the form $A_{0.4}B_{0.6}$ (A) and another region may have a composition of the form $A_{0.6}B_{0.4}$ (B), wherein the indices indicate the proportions. It is likewise conceivable that the target is provided with a gradient of a chemical composition, e.g., a lateral gradient of chemical composition from $A_{0.4}B_{0.6}$ on one end of the target to $A_{0.6}B_{0.4}$ at the other end of the target.

The "ablation source" refers preferably to a device that transfers energy, preferably thermal energy, to the target. The ablation source dissolves molecules, atoms and/or ions of the target material and converts them into a gaseous state or a plasma. Therefore, the ablation source in particular must transfer a sufficient amount of energy to the target material so that atomic and/or molecular bonds of the target material are dissolved.

Preferably, the ablation source does not have to be located in the deposition chamber, where the actual deposition, i.e. the impingement of the target material on the substrate, takes place.

The method is characterized in that the inhomogeneous target comprises at least two segments, the segments having different chemical compositions, wherein the ablation track is configured to repeatedly cover said at least two segments such that the ablation track defines the average chemical composition of the material flux of the target material towards the substrate.

In this context, a segment preferably designates a partial area of the target that has a specific, preferably homogeneous, chemical composition, wherein the at least two segments comprise different chemical compositions.

For example, one of the segments may have a composition of the form $A_xB_{1-x}$ and the second segment may have a composition of the form $A_yB_{1-y}$, where the indices x and y may take values between 0 and 1 and A and B may be elements, compounds and/or alloys.

Impingement of the ablation source along an ablation track creates a material flux with an average chemical composition, wherein the (temporal) average chemical composition of the gas or plasma plume is determined by the path of the ablation track with respect to the segments differing in their composition.

In some embodiments the target may be divided into an inner segment and an outer segment. The term outer segment is preferably understood to mean that along a surface of the target the outer segment spatially surrounds the inner segment.

A higher number of segmentations, for example 3, 4, 5, 6, 7, 8 or more segmentations may also be preferred. The segmentations may have regular or irregular extensions. The target may preferably be divided into segments similar to a pie. A higher number of segmentations with different chemical compositions is advantageous in that more options can be provided for selecting the chemical composition of the material flux and thus for coating on the substrate.

In some embodiments of the invention a movement of the ablation point to define the ablation track is performed by deflecting the ablation beam and/or by moving the target, preferably by rotating the target.

Thus, by changing the position of the ablation point on the surface of a target an ablation track is formed on the target. The ablation track can, for example, have the shape of a one-dimensional straight or curved line, a two-dimensional shape such as an ellipse or a circle, or any other geometric shape. Various possibilities are conceivable as to how the ablation track on the target can result.

In a preferred embodiment of the invention the at least two segments are radially aligned and do not obey rotational symmetry and wherein the ablation track relates to a circular movement of the impingement point of the ablation beam on said target, preferably resulting from a rotation of the target. It may also be preferred that the one or more segments are formed by mirrored Archimedean spirals. The latter is referred to as heart shaped in the following.

As mentioned above in preferred embodiment the ablation track is a circle with a radius R between the centre of the target and the point of impact of the ablation beams. In this case the average chemical composition of the gas or plasma plume depends on how much of the path length of the circle, the ablation track sweeps across a segment of the target. For radially aligned segments that do not obey rotational symmetry, e.g. segments of a heart shape, changing the radius R of the ablation track, results in changing the path length per segment of the target and thus the chemical composition of the gas or plasma plume. Hence, choosing a radius for an ablation track may essentially determine the average chemical composition of the material flux to be deposited on the substrate.

It is particularly preferred that the ablation track results from a rotation of the target. In this embodiment, the target is preferably segmented such that the target is divided into an inner segment and an outer segment, with the inner segment being for example elliptical. An ellipse can be geometrically conceived by a unit circle stretched on the x-axis around a and on the y-axis around b, where the parameters a and b are crucial for a geometric description of the ellipse, preferably where a > b holds. In this embodiment, the ablation track is determined by preferably two parameters, namely the distance R between the centre of the target and the point from which the ablation track meets or crosses a boundary region between the first and second segments and the angle $\varphi$, where the angle $\varphi$ is formed between a horizontal line extending from the ablation track to the centre of the target and the line extending from the point from which the ablation track meets or crosses a boundary region between the inner and the outer segment. For an exemplary illustration, assume that the inner segment has the chemical composition $A_xB_{1-x}$ and the outer segment has the composition $A_yB_{1-y}$. In this preferred embodiment, the time-averaged chemical composition of the material flux can be given analytically, see also by Wenckstern et al. (2020). If the position of the ablation point R is chosen such that it is smaller than the shorter axis of the ellipse b, the composition of the inner segment is reproduced. Consequently, the composition obtained is the composition y of the outer segment for R > a. A variation of the composition between x and y can be realized for values of R between a and b. Advantageously, the chemical composition of the material distribution can be achieved in a well-defined manner by a simple geometric change of the radial position R of the ablation point on the target, where the ablation track may traverse repeatedly said segments along the defined circle. By changing R in situ and stepwise during ablation, one can advantageously obtain a thin film material distribution with (quasi-) continuous lateral and/or vertical material gradients, which may be defined by the relative movement between mask (with the at least one aperture) and substrate.

In a further preferred embodiment of the invention the method is characterized in that according the target material comprises an alloy with two or more alloy constituents, preferably a semiconductor alloy, and wherein the target, comprises at least two segments, the segments having chemical compositions which differ in the composition of the two or more alloy constituents.

In a further preferred embodiment of the invention the method is characterized in that the target is a semiconductor element, compound or alloy, preferably selected from the group consisting of Magnesiumzincoxide (Mg, Zn)O, Silicongermanium (Si, Ge), Silicongermaniumcarbon (Si, Ge)C, Di-Indiumgallium-Trioxide (In, Ga)$_2$O$_3$, Di-Aluminum-gallium-Trioxide (Al, Ga)$_2$O$_3$, Indiumgalliumarsenide (In, Ga)As, Aluminumgalliumarsenide (Al, Ga)As, Indiumgalliumnitride (In, Ga)N, Aluminumgalliumnitride (Al, Ga)N, Cadmiumzincoxide (Cd, Zn)O, Zincoxidesulfide Zn(O, S), Aluminumgalliumindiumarsenide (Al, Ga, In)As, Indiumgallium (In, Ga), Arsenicphosphorus (As, P), Aluminumgalliumindiumnitride (Al, Ga, In)N, Magnesiumzinccadmiumoxide (Mg, Zn, Cd)O, Aluminumgalliumindium (Al, Ga, In), Di-Aluminumindiumgallium-Trioxide (Al, In, Ga)$_2$O$_3$, Di-Ironirridiumcrom-Trioxids (Fe, Ir, Cr)$_2$O$_3$, Galliumindiumphosphorarsenic (Ga, In, P, As) and/or Aluminium gallium indium arsenic (Al, Ga, In, As).

It is preferred in the context of the invention that the material of the target (target material) is a binary, ternary or quaternary semiconductor alloy. In terms of the invention, this preferably means that the target comprises a material that is at least partially formed by a semiconductor alloy, the alloy preferably consisting of two, three or four alloy partners. An example of a ternary alloy is (Mg, Zn)O, i.e. an alloy of magnesium, zinc and oxygen.

In a further preferred embodiment of the invention the method is characterized in that the ablation source is a sputtering source, an electron beam source, an ion beam source, a laser, preferably a pulsed laser.

Said ablation sources have proven to be particularly reliable in providing sufficient energy to break the atomic and/or molecular bonds between the atoms of the target to generate the material flux of the gas or plasma plume towards the substrate.

An ion beam source is used to generate ions. Various known methods and devices can be used for this purpose.

In a sputtering ion source, particles are accelerated toward a solid, the sputtering target, where they "sputter" and ionize atoms of the material. The ions are then extracted by electric fields to form an ion beam, for example, for impinging the target to form the material flux as described.

An electron beam source refers to a device with which a beam of electrons can be generated. Since electrons lose their energy very quickly in the air of the atmosphere, electron beams require a vacuum or at least a significantly reduced gas pressure compared to the atmosphere. In most designs, the electrons are emitted from a suitable cathode and accelerated toward an anode by a constant electrical potential difference, with no restriction to this design. Often the beam leaves the electron beam source through a hole, the size of which also determines the beam diameter. Additional electrodes, often ring- or tube-shaped, as well as magnetic fields within the electron optics provide for focusing or further acceleration of the electron beam. They can be located between the cathode and the anode. Accordingly, one speaks of electrostatic or magnetic focusing. Axially symmetrical magnetic fields are preferably used for magnetic focusing. The electron beam can be deflected from its direction by a deflection system, i.e., by transverse electric or magnetic fields, in order to make it impinge at a specific location. This allows the point of impact of electron beams on the target to be controlled and varied particularly well.

Pulse lasers are a particular preferred ablation source in the process according to the invention. A pulse laser preferably refers to a laser that preferably does not emit photons continuously, but in (preferably periodic) pulses. Advantageously, particularly high-power densities can be achieved with pulse lasers. The maximum peak power of a pulse laser is determined by the pulse duration and the pulse frequency as well as by the pump energy with which the occupation inversion is built up. One can increase the peak pulse power by shortening the pulse duration, shortening the repetition frequency or rate of the laser. In some embodiments it may be preferred to employ laser pulses, with pulse durations in microsecond, nanosecond, femtosecond range or less.

Moreover, using a pulsed laser source allows for a particular precise control over the quantity of target material deposited on a given location of a substrate. For instance, in some embodiments about 10 laser pulses correspond to the deposition of a monolayer. In some embodiments about 100 laser pulses may correspond to a control of the thickness of the deposited layer to between 1-5 nm.

In a further preferred embodiment of the invention the method is characterized in that the material distribution of target material on the substrate comprises a lateral material gradient, a vertical material gradient, patterned layers and/or a three-dimensional gradient and/or pattern in a stack of layers.

Preferably, any pattern can also be formed in a stack of material layers. Advantageously, the method according to the invention allows different possibilities to apply material distributions on the substrate. In particular, the method according to the invention allows several material distributions to be applied to the same substrate. The substrate may have a small surface area, for example a surface area of less than about 1 cm$^2$.

A material gradient preferably refers to a varying chemical composition of the material that is coated on the substrate. In particular, an imbalance is present in a material gradient, meaning that more particles of a certain type are present at one area of the substrate than on another area. Quantification of the number of particles may be indicated, for example, by concentration, in particular as the proportion of an element, compound and/or alloy in a given spatial region of the substrate, for example within one or more centimetres, millimetres and/or micrometres. In the context of the invention, the term gradient preferably relates to a material gradient, particular preferably to a gradient of target material (composition) on the substrate.

In particular, a material gradient can be characterized by an essentially monotonically increasing or decreasing variation of a certain proportion of an element, compound and/or alloy. The material gradient can, for example, have a linear and/or quadratic course. The material gradient can also be continuous or step-wise.

A quadratic course of a material gradient can be mathematically described by the equation

$$x = x_0 + x_1 d \; + \; x_2 d^2$$

where x indicates concentrations of an element, a compound and/or an alloy, $x_i$ preferably represent coefficients which are preferably constant and d indicates the argument of the function (e.g. a lateral and/or vertical dimension).

Accordingly, a linear course of a material gradient is given by

$$x = x_0 + x_1 d$$

It may also be preferred for some applications that the course of the material gradient is given by a polynomial of the form

$$x = x_0 + x_1 d + x_2 d^2 + x_3 d^3 + ....$$

By means of such a Taylor series, arbitrary non-linear functions and thus non-linear material gradients can be provided.

The expression "lateral material gradient" preferably refers to a material gradient along the surface of the substrate, i.e. along one and/or two dimensions.

The term "vertical material gradient" preferably refers to a material gradient applied vertically, i.e., in the growth direction of the coating.

A patterned layer preferably refers to a layer, the structure of which is characterized by repeated or parallel uniform occurrence, i.e. a design form characterized by uniform repetition (reproduction). A three-dimensional gradient designates preferably a material gradient, which is preferably formed in all 3 spatial dimensions. A possible arrangement for a 3-dimension gradient is a quantum well structure for which the chemical composition of the first layer (barrier), the chemical composition of the well layer (with smaller band gap) and the concentration of the third layer (barrier, similar or identical to the first layer) are changed in parallel in order to keep a constant well depth while changing the absorption edge. Another possible arrangement is the generation of a spiral-shaped arrangement which can influence the angular momentum of light.

In a further preferred embodiment of the invention the method is characterized in that the material distribution of target material on the substrate comprises a lateral and/or vertical material gradient, the lateral and/or vertical material gradient is an alloy, preferably a semiconductor alloy, of the general composition $A_xB_{1-x}$, where A and B each identify alloy constituents and x denotes a proportion of the alloy constituent A and is between 0 and 1, wherein the material gradient changes regarding the proportion of the alloy constituent wherein preferably the proportion of at least one alloy partner changes with a gradient of at least 3% / mm, preferably at least 5 % / mm, particularly preferably at least 10 % / mm.

Advantageously, the steepness of material gradients can be achieved particularly well with a constant speed of the material flow of the target towards the substrate in combination with a constant speed of the mask and a constant variation of the material flow, the latter in particular by changing the ablation track. The size of the aperture of the mask may be relevant (and selected for) in terms of how accurately target material may form gradients laterally on the substrate. Thus, advantageously, optimised material gradients and/or concentration gradients of materials to be coated on the substrate can be achieved with particular ease by the method according to the invention. In particular, the material gradients can advantageously be provided in a reproducible manner. Furthermore, desired material gradients can be produced if the mask moves constantly, i.e. continuously, or also stepwise, i.e. if it covers a distance, remains in the position for a certain period of time and repeatedly performs this change of position.

It may also be preferred that the material gradient comprises a binary, ternary or quaternary alloy, the concentrations or proportions of the individual alloying partners being coupled to one another via an index x. Depending on the selected material system of an example alloy comprising the alloying partners A and B, the index x for the alloy $A_xB_{1-x}$ can preferably run from 0 to 1 or assume a value between 0 and 1. Intermediate values such as 0 to 0.9, 0.8, 0.7, 0.6, 0.5, 0.4, 0.3, 0.2 or even 0.1 may also be preferred. Similarly, it may be preferred to run x between 0.1, 0.2, 0.3, 0.4, 0.5, 0.6, 0.7, 0.8, or 0.9 to 1.0. Any combination, for example, 0.2 to 0.5 or even 0.1 to 0.3, is also conceivable. The general form $A_xB_{1-x}$ is applicable to binary, ternary or quaternary alloys.

For example, the alloying partners A and B can also be characterized by a semiconductor mixture or a semiconductor alloy with three or more alloying partners, wherein proportions of individual, two or all alloying partners can be varied

In particular, the index x may be a measure of the change in chemical composition of the material gradient. The preferred change with a gradient of at least 3%/mm, preferably of at least 5%/mm, particularly preferably at least 10 % / mm. can also be represented by the notation $\frac{dx}{dr} \geq 0.03/mm$ , preferably $\frac{dx}{dr} \geq 0.05/mm$ , where r indicates the position on the substrate. Furthermore, it may be preferred that the gradient is increased by about 10%/mm, by about 15%/mm, by about 20%/mm, by about 25%/mm, by about. 30 %/mm, i.e. also $\frac{dx}{dr} \geq 0.10/mm, \frac{dx}{dr} \geq 0.15/mm, \frac{dx}{dr} \geq 0.20/mm, \frac{dx}{dr} \geq 0.25/mm, \frac{dx}{dr} \geq 0.30/mm$ .

Such high values in terms of the gradient progression were not possible with the prior art methods for the production of thin layers or thin films. In particular, it is advantageously possible to apply such steep gradients to a small substrate having a surface area of about 1 cm$^2$ or less.

The values for the gradient have proven to be particularly advantageous in that the substrate area on which the coating is used can be utilized much better. For example, a smaller construction dimension with the same functionality may be achieved. More material distributions, for example in the form of components, can advantageously be applied to the same substrate. In other words, the same number of devices can be placed on a smaller area on a given substrate leading to a more economic use of target material and substrate.

In a further preferred embodiment of the invention the method is characterized in that for each deposition location on the substrate a desired chemical composition, a relative position between the mask and/or substrate, an ablation position, an ablation track and/or one or more process parameters are saved in a look-up table for quality control and/or reproduction of the material distribution.

Other parameters may also relate to the process gas, for example the specific compound of the process gas, the mixing ratio in a gas mixture, the energy with which the ablation source hits the target with ablation beams, for example a pulse laser. Values regarding pulse frequency could also be relevant to the desired material distribution. Parameters or parameter ranges regarding these deposition conditions can preferably be stored in the look-up table. Also values regarding the chemical composition of the target can be stored in the look-up table.

The embodiment may be of particular advantage for reproducing of a given material distribution on the substrate, such as lateral and/or vertical material gradients and/or patterns comprising layers of common and/or different material gradients. By reproducibility is meant here that a specific (target) material distributions can be repeatedly produced and/or deposited as often as desired. For this purpose, values regarding the process parameters can be stored in a look-up table in order to (re-)produce the corresponding thin film with the desired material distribution again. This is particularly advantageous and well suited for industrial applications for the manufacture of components and mass production, for example for semiconductor and/or microsystem technology.

Look-up tables (LUT) or conversion tables are used to record, define and store information and preferably to call up and implement these during runtime of the process according to the invention, for example in a coating system in which the process takes place. Advantageously, this avoids complex prior iterations on experiments, simulation and/or complex calculations.

In a further preferred embodiment of the invention the method is characterized in that for different deposition locations on the substrate different process parameters, preferably a different temperature, pressure, background gas, ablation frequency and/or ablation energy, may be employed.

Thereby the process parameters for each individual layer or deposition location may be optimized during a production process. For instance, for certain chemical composition different temperature ranges for the substrate surface may be desired to ensure optimal deposition. The further degree of flexibility adds to the precision and reproducibility of material distribution achievable. The improved reproducibility is particularly due to the fact that, by means of the process according to the invention, parameters can be newly selected and set for each new point or area at which the material is to be coated on the substrate and/or the mask is moved. This also has an advantageous effect on the overall material quality of the material to be coated, since the composition of the material to be applied cannot vary randomly due to a selection of process parameters that is fixed and/or can be adjusted. In the coating processes known in the prior art, process parameters, such as the temperature of the substrate and/or the pressure, can have a significant influence on the material to be coated on the substrate, since these are usually prescribed and there is no further possibility of control. Advantageously, process-relevant parameters can be readjusted in the process according to the invention, so that advantageously an improved reproducibility and also material quality is achieved.

By impinging the target with one or several ablation beams of the ablation source, the target material is vaporized. The amount of atoms, ions or larger clusters in the vapor to form the plasma can vary from ablation source to ablation source and from target to target. The vaporized material can either move ballistic or be guided by electric fields and come through the aperture onto the substrate, where layer formation occurs.

To ensure that the plasma particles reach the substrate and are not lost through scattering by other gas particles, for example a process gas, it is preferable to work under negative pressure. Typical working pressures are in the range of about $10^{-4}$ Pa to about 10 Pa. The gas pressure in the process chamber is preferably chosen low enough that the target particles reach the substrate without colliding with gas particles of the process gas. Preferably, therefore, the gas particles of the process gas have a mean free path length of at least the distance of the target to the substrate.

The process gas can be preferably a gas that allows the target material to undergo a desired chemical reaction with the substrate, resulting in a stable and long-lasting coating.

Depending on the properties of the process gas, very different effects of the plasma can be achieved. Accordingly, a large variety of process gases are used. In some embodiments the process gases may be selected from a group consisting of without limitation oxygen, hydrogen, tetrafluoromethane, argon, helium and nitrogen dioxide.

The particles of the plasma preferably do not necessarily remain in place where they meet the substrate, but may move along the surface (surface diffusion), depending on how high their energy is, in order to find a more energetically favourable place. These are preferably places on the crystal surface with as many neighbours as possible.

With an increased temperature, the mobility of the atoms and molecules in the target layer increases, so that the release of the bonds present therein is facilitated. This may also be relevant for the coating efficiency of target material to react with the surface of the substrate. Depending on the material of the thin film, additional phase transformations can occur at sufficiently high temperatures. In particular, the temperature at the substrate has thus an influence on the homogeneity or inhomogeneity with respect to the layer thickness on the substrate. In some embodiments, the higher the temperature of the substrate, the more homogeneous the layer thickness may be. In particular, the temperature at the substrate, which can preferably be adjusted by the heating element operatively connected to the substrate, can also advantageously regulate the chemical composition of the material to be coated. For example, in the case of an $(Al,Ga)_2O_3$ compound and/or alloy, the setting of an increased temperature can cause gallium suboxides to form, which evaporate during the process, which in turn advantageously leads to the aluminium content being increased.

In a further preferred embodiment of the invention, the method is characterized in that the thin film material has a layer thickness of up to 1000 nm, preferably up to 500 nm, up to 100 nm, 20 nm or up to 5 nm. In preferred embodiments a thin-film material thus refers to a layer thicknesses of less than 1 mm.

Advantageously, the layer thickness of the material distribution on a limited area of the wafer can be controlled optimally and reliably by using a mask in the method according to the invention. This can be relevant when different layer thicknesses are desired on the same substrate. Advantageously, the process according to the invention also allows the layer thickness on substantially the entire substrate to be controlled reliably.

The thicker the layer, the more target material is required. A higher coating thickness is also often accompanied by higher stability on the substrate itself. With regard to stability adhesion strength, hardness and abrasion resistance may also play a role. Thermal and chemical resistance can also vary from layer thickness to layer thickness and depend on the material. The layer thickness may also have an influence on the application in which the thin film produced is to be used, since in optics, for example, the layer thickness directly influences the reflection and transmission behaviour.

In a preferred embodiment of the invention the method is characterized in that the laser strikes the target non-axially, preferably with an angle between 10° and 70°, more preferably between 30° and 50°, most preferably at 45°, with respect to a normal of the target.

In a further preferred embodiment of the invention the method is characterized in that the mask and the substrate are spaced with less than 100 mm, preferably less than 10 mm, less than 1 mm or less than 100 $\mu$m. Herein, the preferred distance between the mask and the substrate may be chosen according to the size of the aperture. In particular, the size of the aperture may influence how collinear a beam of plasma material is after passing the aperture, such that the distance between substrate and mask may be chosen sufficiently small to ensure the desired resolution. A thickness of the mask and the distance between the mask and the substrate within reasonable limits in the context of the invention may have an influence on the particle flux distribution after diffusion through the aperture. If there is sufficient diffusion, only the positioning accuracy and minimum step size of the positioning of the mask and/or substrate is critical. How obliquely, in particular at what angle, the particles of the target material fall in depends on the distribution of the particles and the position of the mask in relation to the centre of the plasma. The distribution of the particles depends in particular on the pressure. With thicker masks, oblique "edge beams" are reduced to a greater extent, since the particles hit the edges in the aperture of the mask. The angular distribution behind the mask in such cases becomes narrower and the distance can be increased if necessary for the same resolution. For sufficiently high resolutions, the aperture and the step size of the positioning should then be reduced. However, this will also increase the process time, since fewer particles will pass through the mask and an increased number of pulses from the ablation source will have to be used at each of the increased number of deposition positions of the mask in order to achieve the same layer thickness in the end.

In a further preferred embodiment of the invention the method is characterized in that the aperture has a diameter between 5 $\mu$m and 1000 $\mu$m, preferably between 20 $\mu$m and 500 $\mu$m, more preferably between 50 $\mu$m and 200 $\mu$m. Said dimensions allow for a particular precise deposition of target material to a desired location on the substrate.

The size of one or more apertures on the mask is an important parameter for the material distribution. The smaller the aperture of a mask, the more positions have to be traversed by the mask in order to be able to produce a desired material distribution, for example a material gradient, on the substrate. Accordingly, the time to obtain the desired material distribution on the substrate may be higher for one or more small apertures. On the other hand, the smaller the aperture of the mask, the more precisely a desired material distribution can be deposited on a desired location on the substrate. The aforementioned ranges of sizes of the apertures have proven to present an optimal regime in terms of speed and precision.

In a further preferred embodiment of the invention the method is characterized in that the at least one aperture exhibits the shape of a circle, a slit, a strip, a triangle, a rectangle, a square or an arbitrary geometric shape.

Advantageously, the specified geometrical configurations of the apertures allow in this regard to regulate the geometrical shape, the outer shape and/or the contours of the material distribution on the substrate. In particular, a shape of the material distribution on the substrate can be produced that substantially corresponds to the shape of the aperture. In addition, any geometric shapes of the material distribution on the substrate can also be produced, depending on a combination of different and/or distinct shapes of the apertures of the mask.

In a further preferred embodiment of the invention the method is characterized in that the mask comprises two or more apertures, preferably of equal dimensions and/or in a periodic arrangement, such that two or more material distributions, preferably identical material distributions, may be formed simultaneously on said substrate.

A plurality of apertures is particularly advantageous in that multiple desired material distributions can be produced on the substrate in parallel, i.e., simultaneously. The parallelized generation of desired material distributions on the substrate may be of particular advantageous for industrial applications. For example, multiple components of a semiconductor device can be fabricated in parallel in terms of desired material distributions, such as lateral and/or vertical material gradients. It may also be preferred that multiple similar devices be fabricated on the same substrate surface. Compared to prior art methods allowing for only one material distribution to be produced in parallel, production costs and time can be considerably reduced.

Accordingly, with a plurality of similar and/or periodically arranged apertures, a plurality of similar material distributions, such as similar lateral and/or vertical material gradients, can be provided on the substrate. It may also be preferred to separate these material distributions by a subsequent processing, for example by breaking and/or sawing the substrate. Of course, the method according to the invention also allows to produce several homogeneous material distributions (e.g. in certain areas) on the substrate.

It may also be preferred that a covering device is provided on the substrate. A covering device refers preferably to a movable cover that can close desired apertures via a mask, so that a material flux through the covered apertures is no longer possible. In particular, no material distribution can be formed on the substrate via the apertures that are covered. The movability of the covering device can be enabled, for example, by rails along which the covering device can be moved, for example, by one or more actuators. The commands to cover and/or move the mask can be transmitted, for example, by a computing unit located on the covering device.

In a further preferred embodiment of the invention, the method is characterized in that a plurality of masks with different configurations and/or number of apertures can be integrated in a coating system and, in particular, can be used sequentially. A sequential use of several masks preferably means that several masks can be placed continuously and in particular successively between the target and substrate by preferably storing and processing instructions, for example by a computing unit.

A computing unit preferably refers to a unit which is suitable and configured for receiving, transmitting, storing and/or processing data, preferably electromagnetic signals and/or other measurement data. The computing unit preferably comprises an integrated circuit, a processor, a processor chip, microprocessor and/or microcontroller for processing data, as well as a data memory, for example a hard disk, a random access memory (RAM), a read-only memory (ROM) or also a flash memory for storing the data.

In a further preferred embodiment of the invention the method is characterized in that the mask and/or the substrate are laterally movable with respect to each other, wherein a lateral movement of the mask and/or the substrate is provided by an actuator.

In particular, the actuator enables a relative movement between the substrate and the mask. The relative movement may preferably be in one and/or two dimensions. Movement along the direction of growth of the thin film on the substrate may also be preferred if it is desired to induce a change in distance between the mask and the substrate and/or between the mask and the target. Relative movement between the substrate and the mask can be used to produce desired material distributions, such as lateral and/or vertical material substrates, at selectable and chosen areas of the substrate. A movement of the mask is advantageous in that it is particularly easy to implement technically, for example by integrating the mask on an extendable slide rail in combination with an actuator. For example, the mask can then be moved and the substrate is fixed to a holder. In further embodiments, the mask may also be fixed and the substrate moved to cause relative movement between the mask and the substrate. Similarly, it may be preferred that both the substrate and the mask undergo movement.

Advantageously a thin film material composition on a substrate maybe provided by a method according to the described method.

A person skilled in the art appreciates that preferred embodiments disclosed in connection with the method to produce a thin film material composition equally apply to a thin film material composition produced by a method and convey the same benefits.

The thin film layers produced may be used to manufacture microtechnical components or other functional layers. Typical layer thicknesses are in the micrometre and nanometre range, up to monomolecular layers, which advantageously may be patterned as desired by the methods described herein.

The process according to the invention allows thus for the production of one or more semiconductor devices on a substrate. It can particularly well produce one or more devices by producing material distributions, such as vertical and/or lateral material gradients. In particular, the use of the mask between the target and the substrate can preferably regulate and control the device geometry, surface finish, adhesion strength, topography, and/or morphology.

In a further aspect the invention refers to the use of a method for producing a thin film material composition for providing an absorbent element suitable for use in a spectrometer or wavemeter, a p-n-layer, a p-n-layer stack, light emitting structures, quantum well infrared photodetectors, plasmonic structures, a Bragg reflector, nanowires, a superconductive structure and/or a thin film transistor.

In the sense of the invention, an absorption element is preferably a component for absorbing electromagnetic radiation, whereby a photosignal can be generated on the basis of the absorption. The term absorption element is preferably understood to mean absorption elements made of photoconductive materials, i.e. materials which become more electrically conductive upon absorption of electromagnetic radiation. For example, when electromagnetic radiation is absorbed by a semiconductor whose band gap is smaller than the photon energy of the electromagnetic radiation, the number of free electrons and holes increases, so that the electrical conductivity increases.

If an electrical voltage is applied to an absorption element, for example by means of two contacts, the possibly wavelength-dependent absorption of the electromagnetic radiation can be recorded directly as an increase in a photosignal or a photocurrent. Photosignals therefore preferably mean electrical signals which can be detected when electromagnetic radiation is absorbed by the absorption element. Preferably, the photosignals are photocurrents.

By means of a material gradient, which is produced by the method according to the invention, within the absorption element, it is advantageously possible to assign the absorption of different wavelengths to a specific location along the absorption element or the waveguide. As a result, the radiation to be examined can be spectrally analysed, preferably with spatial resolution, with particular precision. In particular, the method according to the invention allows particularly steep material gradients to be produced in this regard.

A spectrometer preferably refers to a device for displaying a spectrum. In contrast to a spectroscope, it offers the possibility of measuring spectra. A spectrum is the intensity as a function of wavelength, frequency, energy or - in the case of elementary particles, atoms or ions - mass. Because of wave-particle duality, these quantities are often equivalent. Thus, the absorption element may preferably be a component of a spectrometer capable of absorbing electromagnetic radiation under investigation.

A wavemeter preferably refers to a device arranged to determine and/or detect a wavelength and/or photon energy of a radiation. Due to the material distribution, in particular a material gradient produced by the method according to the invention, the measurement of the wavelength of the incident radiation in a particularly large wavelength range can be made possible.

The term absorption edge preferably refers to a preferably sharp, i.e. abrupt, transition between different absorption states or strengths. For example, this may mean a region in a preferably electromagnetic spectrum in which an abrupt difference occurs between a region of strong absorption and a region of weak absorption. The absorption edge of a material, in particular a semiconductor with a direct band structure, preferably corresponds to a spectral region in which the absorption coefficient $\alpha$ increases from low values in the transparency region, typically less than 1 to 10 cm$^{-1}$ to large values, typically $10^4$ to $10^5$ cm$^{-1}$. The transparency range preferably denotes a spectral region for photon energies smaller than the absorption edge, while an absorption region denotes a spectral region for photon energies larger than the absorption edge.

A p-n layer denotes a material transition in semiconductors between regions of opposite doping. Regions where the doping changes from negative (n) to positive (p) occur in many semiconductor electrical devices. The special feature of a p-n layer is the formation of a space charge region (also called a junction), which allows current flow in only one direction when an external voltage is applied. Thus, a p-n layer acts like a current valve, which is used, for example, in single-crystal semiconductor diodes and blocks applied current. Advantageously, the process according to the invention makes it particularly easy to produce a p-n layer. Accordingly, a p-n layer stack denotes a stack comprising several p-n layers.

A light-emitting structure preferably denotes a semiconductor device that emits light when electric current flows in the forward direction. In particular, the electrical properties of the light-emitting structure may correspond to those of a diode. In particular, the light-emitting structure may be an LED. The wavelength of the emitted light depends on the semiconductor material and the doping of the diode. The light may be visible to the human eye or in the range of infrared or ultraviolet radiation.

A quantum well infrared photodetector refers preferably to a semiconductor detector for detecting infrared radiation, for instance in the 8...14 μm range. Alternating thin layers, e.g. 30, 40, 50, 60 or more layers, for example comprising III-V semiconductors (e.g. AlGaAs/GaAs) with different bandgaps form quantum wells which absorb infrared radiation and release charge carriers. A quantum well is preferably understood to be a potential well that restricts the freedom of motion of a particle in preferably one spatial dimension so that, for example, a planar region can be occupied. The width of the quantum well significantly determines the quantum mechanical states that the particle can assume. In particular, this leads to the formation of energy levels, i.e., the particle can only assume discrete energy values.

Plasmons denote preferably the quantized fluctuations of the charge carrier density in the solid body called; quantum mechanically they are treated as bosonic quasiparticles. What the photon represents for electromagnetic waves, the plasmon is for oscillations in the Fermi gas of metals. A plasmonic structure can be a particle plasmon (localized surface plasmon), a surface plasmon, and/or bulk plasmon. The first two belong to the plasmon polaritons, since here fluctuations of the electron density couple with electromagnetic fields outside the metal. Strictly speaking, the words "surface and particle plasmons" should thus have the addition polariton, but this addition is usually omitted. Volume plasmons take into account a new mode of oscillation that applies to the whole volume of space. These structures play a prominent role in focusing light onto areas much smaller than the conventional diffraction limit for electromagnetic waves. In particular, it is possible to create regions of extremely high electric field strength that are spatially confined to only a few nanometres. Through this locally limited, extremely high electric field, it is possible to study the interaction of light with a few or perhaps even single atoms or quantum emitters.

A Bragg mirror refers to an efficient reflector used in light guides or in optical resonators. It consists of alternating thin layers of different refractive indices. Usually, the layers consist of dielectrics. That is why the term dielectric mirror is used for such a reflector. At each boundary layer, a part of the electromagnetic wave of the light is reflected according to Fresnel's formulas. If the wavelength is close to four times the optical path length of the layers, then the reflected rays interfere constructively and a high quality reflector is formed. The region where the reflection is very high is called the stopband. Light whose wavelength is within the stop band cannot propagate in the structure.

A nanowire is a fine, elongated piece of metal, semimetal or compound semiconductor with a diameter in the range up to a maximum of about 100 nanometres. Nanowires can be implemented in wide range of several devices, such as superconductive devices or gas sensors.

The production of thin superconducting layers with the method according to the invention allows to handle the variety of parameters influencing the superconducting properties in a particularly well-defined manner. Within a material system, the metallurgical as well as the geometric structure of a layer can be systematically changed; stoichiometry, phases, microstructure and layer structure can be specifically influenced by the process according to the invention and a corresponding choice of preparation parameters.

A thin-film transistor is a special insulated-gate field-effect transistor that can advantageously be used to fabricate large-area electronic circuits. The structure of a thin-film transistor is similar to that of the well-known metal-oxide-semiconductor field-effect transistor (MOSFET). The main differences - apart from the materials typically used - are the subsequently applied semiconductor layer and the frequently large-area gate, i.e. the source or drain and the gate are often located one above the other.

The process according to the invention will be explained in more detail below by means of examples, without being limited to these examples.

**FIGURES**

Brief description of the figures

Fig. 1    Schematic representation of the process according to the invention

Fig. 2    Representation of a change of the Mg (Magnesium) content by the method according to the invention with an unprecedentedly steep gradient in the chemical composition

Fig. 3    Representation of two successively produced samples with one MgO/ZnO (magnesium oxide/zinc oxide) target with nominally identical parameters and mask positions

Detailed description of the figures

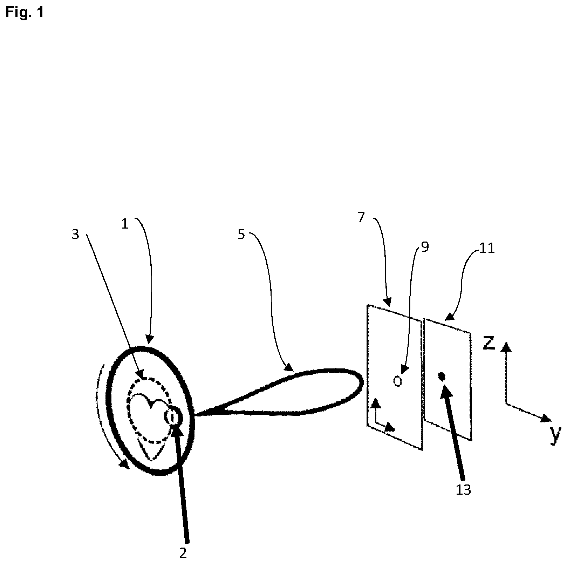

**Fig. 1** is a schematic representation of how the components required for the process according to the invention may be arranged. It should be noted that the drawing is not to scale and is for illustrative purposes only. An ablation source, for example a pulse laser, emits radiation to a target **1,** the target being radially segmented. An orientation is given by coordinate system comprising an y- and z-axis. With this orientation, a material distribution **13** on a substrate **11** can be described. Hence, a plasma plume **5** moves along the x-axis, which is not explicitly drawn. The target **1** is divided into two segments, an inner and an outer segment. The inner part is drawn by a heart, while the outer part surrounds the inner part, the heart shape. The two segments have different chemical compositions.

In particular, due to the segmentation, there is an inhomogeneity with respect to the material composition of the target. The ablation point, i.e. the point of impact on the target, is radially adjustable. A movement of an ablation point **2** leads to an ablation track **3.** This can be achieved, for example, by rotating the target so that the ablation track on the target has the geometric shape of a circle. The rotation of the target **1** is illustrated by an arrow next to the target **1.** Repeated crossing of the ablation track leads to an average chemical composition of a plasma plume **5,** which can be achieved by a repeated rotation. In particular, the ablation track **3** sweeps through both segments. The average chemical composition of the plasma plume **5** depends on the path length of the ablation track **3** through each segment, wherein the segments have different chemical compositions. The plasma plume **5** is created by, for example, a pulsed laser emitting laser beams with sufficient energy so that the atomic and/or molecular bonds of the target are broken and ions result, i.e. the plasma plume **5.**

Between the target **1** and a substrate **11** is a mask **7,** which has at least one aperture **9.** This results in a material distribution **13** on the substrate **11.** The plasma plume **5** passes through the aperture **9** of the mask **7** and is deposited on the substrate **11.** Advantageously, the method according to the invention allows to produce a desired material distribution **13** on the substrate. In particular, the method according to the invention allows the chemical composition of the material flux **5** to be controlled at any position on the substrate **11.** In particular, the mask **7** decouples the chemical composition of the material flux **5** from the substrate position on which it is to be deposited. Relative movement between the mask **7** and the substrate **11** determines the position on the substrate **11** to which the selected chemical composition of the material flux **5** is to be deposited to build the desired material distribution **13.** The chemical composition of the material flux **5** results from ablation track **3** on the target **1.** It is a particular advantage of the method, that the material distribution can be regulated in the sub-mm area with unprecedented precision. In particular, the amount of material of a particular chemical composition located on the substrate along a millimetre, for example, can be significantly increased compared to methods known in the prior art. Moreover, the method according to the invention makes it possible to produce the material distribution **13** in a reproducible manner.

The material distribution **13** can be a lateral and/or vertical material gradient. A vertical material gradient results, for example, from the formation of a varying ablation track **3** and a fixed position of the mask **7** above the substrate **11,** i.e. there is no relative movement between the mask **7** and the substrate **11** to form a vertical material gradient. A lateral material gradient results, for example, from a relative movement between mask **7** and substrate **11** in combination with the formation of a varying ablation track **3** on the target **1.** A homogeneous material distribution on the substrate **11** results when the ablation track is held fixed in combination with a relative movement between the mask **7** and the substrate **11.**

It may also be preferred that the mask **7** has several apertures **9.** This advantageously results in the possibility of producing several material distributions **13,** on the substrate **11** in parallel. In particular, the surface area of the substrate **11** can thereby be better utilized and more material distributions **13** and thus more elements can be formed on the same substrate **11.**

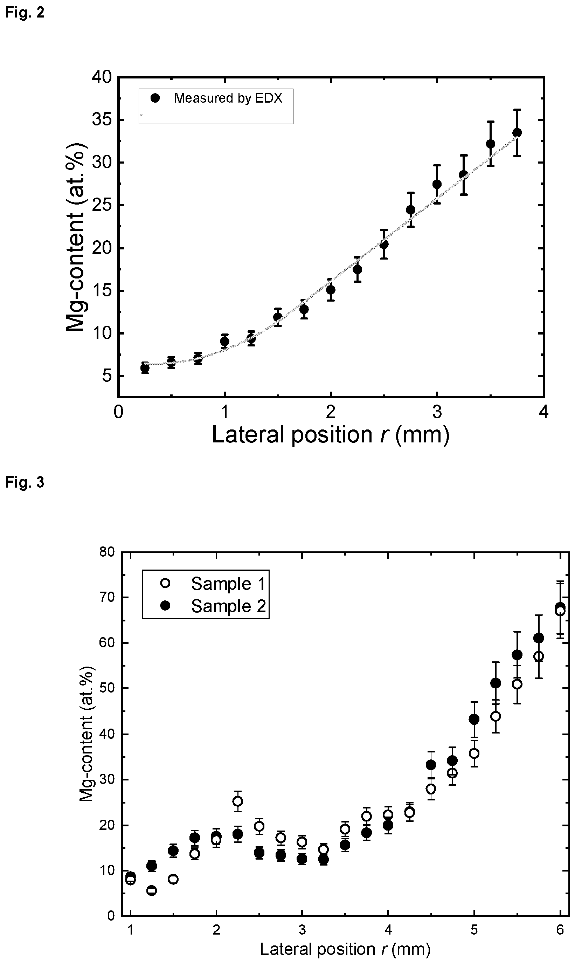

**Fig. 2** shows a measurement result of an unprecedentedly steep material gradient obtained from the method according to the invention. For this purpose, a target was prepared with segments of the materials A: ZnO (zinc oxide) and B: $Mg_{0.5}Z_{0.5}O$ (magnesium zinc oxide). The heart-shaped form of the inner target segment composed of two mirror-image Archimedean spirals of material A with an outer material B guarantees a directly proportional relationship between radial ablation point on the target and the chemical composition of the ablated material flux $A_xB_{1-x}$, that is, x=x(R). A spatially linear material gradient along a geometric line was realized on a 10x10 mm$^2$ a-plane (2-1-10) $Al_2O_3$ substrate, wherein the numbers inside the bracket correspond to miller indices. The mask **7** used during the deposition had an aperture **9** with a width of about 500 $\mu$m. The stepwise displacement of the substrate behind the mask was automatically controlled by a computer program connected to an electric motor. To avoid possible re-evaporation effects at high temperatures on the gradient, the deposition was carried out at room temperature. The minimum (maximum) magnesium concentration in the film is x=0.06 (x=0.34); the material gradient dx/dr pronounced in the linear part of the gradient between $r$=1.25 mm and $r$=3.75 mm can be given as approx. 0.096/mm and illustrates the superior working principle of the method according to the invention. **Fig. 2** shows the dependence of the Mg-content (magnesium) x in the thin film on the sample position r along the material gradient. The Mg-content increases systematically and depends, directly and almost exactly linearly on the sample position. The solid line shown represents the expected, calculated composition, while the measurement results were obtained by energy dispersive X-ray spectroscopy (EDX). The nonlinear part at the beginning of the gradient is expected from the target geometry and can be reproduced as well from the model with excellent agreement which shows the necessarily precise control over the lateral chemical composition for the approach.

**Fig. 3** shows a measurement result of two subsequently produced material gradients obtained from the method according to the invention to prove the reproducibility of the approach. For this purpose, a target was prepared with segments of the materials A: ZnO (zinc oxide) and B: MgO (magnesium oxide). The heart-shaped form of the inner target segment was similar to the target used for the sample shown in **Fig. 2** composed of two mirror-image Archimedean spirals of material A with an outer material B. A spatially linear material gradient along a geometric line was realized on a 10x10 mm$^2$ a-plane (2-1-10) $Al_2O_3$ substrate, wherein the numbers inside the bracket correspond to miller indices. The mask **7** used during the deposition had an aperture **9** with a width of about 500 $\mu$m. In contrast to the sample shown in **Fig. 2,** in this case the mask **7** in front of the sample was moved along the y-axis direction in **Fig. 1** in a more sophisticated approach using a linear actuator with feedthrough mounted on the outside of another PLD chamber on top of an xz-manipulator to adjust the distance of mask to substrate (x-direction) as well as the z position of the aperture prior to the deposition of the material gradient. To avoid possible re-evaporation effects at high temperatures on the gradient, the deposition was carried out at room temperature here as well. The minimum (maximum) magnesium concentration in the films is about x=0.08 (x=0.68); the material gradient dx/dr pronounced in the linear part of the gradient between $r$=3.25 mm and $r$=6.00 mm can be given as approx. 0.20/mm and was designed to be even steeper than for the sample in **Fig 2.** Both material gradients exhibit essentially the same concentration gradient as function of lateral position. The nonlinear and nonideal dependency of the material gradient with a local maximum in the Mg-content below about $r$=3 mm is due to a nonideal Archimedean spiral shape of the borders of the two target segments caused by accidentally unideal distribution of the target powders in the target production process as well as increased target wear at the time of deposition. Nevertheless, the almost exact reproduction of the nonideality within both material gradients further proves the superior reproducibility of the thin film composition in this approach. **Fig. 3** shows the dependence of the Mg-content x (magnesium) in the thin films on the sample position r along the material gradient for two subsequently produced material gradients for nominally identical deposition parameters as well as target and mask positions. The Mg-content increases systematically and depends, directly and almost exactly linearly on the sample position for r $\geq$ 3.25 mm and agrees very well for both samples. The measurement results were obtained by energy dispersive X-ray spectroscopy (EDX). The nonlinear part with a local maximum in the Mg-content at the beginning of the gradient is expected from the nonideal target geometry and can be reproduced as well for both samples with excellent agreement which shows the necessarily precise control and reproducibility of the lateral chemical composition for the method according to the invention. Deviations of the Mg-content as function of lateral position for both samples are either within the measurement uncertainty of the EDX method or in agreement with the uncertainty in the positioning of the laser spot on the target surface and can be further reduced with more exact target positioning actuators.

**LIST OF REFERENCE SIGNS**

| | |
|---|---|
| 1 | Target |
| 2 | Ablation point |
| 3 | Ablation track |
| 5 | Material flux/plasma plume |
| 7 | Mask |
| 9 | Aperture |
| 11 | Substrate |
| 13 | Material distribution |

**BIBLIOGRAPHY**

Jilani, Asim, et al. "Advance deposition techniques for thin film and coating." Modern Technologies for Creating the Thin-film Systems and Coatings 2 (2017): 137-149.

Miller, N. Carl, and George A. Shirn. "CO-SPUTTERED Au-SiO2 CERMET FILMS." Applied Physics Letters 10.3 (1967): 86-88.

Sakai, Joe, et al. "Control of Lateral Composition Distribution in Graded Films of Soluble Solid Systems A1-xBx by Partitioned Dual-Beam Pulsed Laser Deposition." Coatings 10.6 (2020): 540.

von Wenckstern, Holger, et al. "A Review of the Segmented-Target Approach to Combinatorial Material Synthesis by Pulsed-Laser Deposition." physica status solidi (b) 257.7 (2020): 1900626.

von Wenckstern, Holger, et al. "Continuous composition spread using pulsed-laser deposition with a single segmented target." CrystEngComm 15.46 (2013): 10020-10027.

Kneiß, Max, et al. "Combinatorial material science and strain engineering enabled by pulsed laser deposition using radially segmented targets." ACS combinatorial science 20.11 (2018): 643-652.

**Claims**

1. A method of producing a thin film material composition on a substrate (11) with a desired material distribution (13) comprising

   a) providing an ablation source, the substrate (11) and a target (1) comprising target material which is inhomogeneous and to be deposited onto the substrate (11), the inhomogeneous target (1) comprises at least two segments, the segments having different chemical compositions,
   b) emitting an ablation beam onto the target (1) along an ablation track (3) by means of the ablation source, such that the target material is ablated and deposited on the substrate (11) forming the thin film material composition, wherein a chemical composition of a material flux (5) of target material towards the substrate (11) is defined by an average composition of target material along the ablation track (3)

   **characterized in that**

   the ablation track (3) repeatedly covers said at least two segments such that the ablation track (3) defines the average chemical composition of the material flux (5) of the target material towards the substrate (11) and a mask (7) comprising at least one aperture (9) is located between the target (1) and the substrate (11), wherein the mask (7) and the substrate (11) are presently positioned moveable with respect to each other allowing for selectively depositing the chemical composition of the material flux (5) of target material on the substrate (11) to yield the desired material distribution (13).

2. Method according to one or more of the preceding claims
**characterized in that**
a movement of an ablation point (2) to define the ablation track (3) is performed by deflecting the ablation beam and/or moving the target (1), preferably by rotating the target (1).

3. Method according to one or more of the preceding claims
**characterized in that**
the at least two segments are radially aligned and do not obey rotational symmetry and wherein the ablation track (3) relates to a circular movement of the impingement point of the ablation beam on said target (1), preferably resulting from a rotation of the target (1).

4. Method according to one or more of the preceding claims
**characterized in that**
the target material comprises an alloy with two or more alloy constituents, preferably a semiconductor alloy, and wherein the target (1) comprises at least two segments, the segments having chemical compositions which differ in the composition of the two or more alloy constituents.

5. Method according to one or more of the previous claims
**characterized in that**
the ablation source is a sputtering source, an electron beam source, an ion beam source, preferably a pulsed laser.

6. Method according to one or more of the preceding claims
**characterized in that**
the material distribution (13) of target material on the substrate (11) comprises a lateral material gradient, a vertical material gradient, patterned layers and/or a three-dimensional gradient and/or pattern in a stack of layers.

7. Method according to one or more of the preceding claims
**characterized in that**
the material distribution (13) of target material on the substrate (11) comprises a lateral and/or vertical material gradient, the lateral and/or vertical material gradient is an alloy, preferably a semiconductor alloy, of the general composition $A_xB_{1-x}$, where A and B each identify alloy constituents and x denotes a proportion of the alloy constituent A and is between 0 and 1, wherein the material gradient changes regarding the proportion of the alloy constituent wherein preferably the proportion of at least one alloy partner changes with a gradient of at least 3% / mm, preferably at least 5 % / mm, particularly at least 10 % / mm.

8. Method according to one or more of the preceding claims
**characterized in that**
the aperture (9) has a diameter between 5 $\mu$m and 1000 $\mu$m, preferably between 20 $\mu$m and 500 $\mu$m, more preferably between 50 $\mu$m and 200 $\mu$m.

9. Method according to one or more of the preceding claims
**characterized in that**
the at least one aperture (9) exhibits the shape of a circle, a slit, a strip, a triangle, a rectangle, a square or an arbitrary geometric shape.

10. Method according to one or more of the preceding claims
**characterized in that**
the mask (7) comprises two or more apertures (9), preferably of equal dimensions and/or in a periodic arrangement, such that two or more material distributions (13), preferably identical material distributions (13), may be formed simultaneously on said substrate (11).

11. Method according to one or more of the preceding claims
**characterized in that**
the mask (7) and/or the substrate (11) are laterally movable with respect to each other, wherein a lateral movement of the mask (7) and/or the substrate (11) is provided by an actuator.

12. Use of a method for producing a thin film material composition according to any one of the preceding claims 1-11 for providing an absorbent element suitable for use in a spectrometer or wavemeter, a p-n-layer, a p-n-layer stack, light emitting structures, quantum well infrared photodetector, plasmonic structures, a Bragg reflector, nanowires, a superconductive structure and/or a thin film transistor.

**Patentansprüche**

1. Verfahren zum Herstellen einer Dünnschichtmaterialzusammensetzung auf einem Substrat (11) mit einer gewünschten Materialverteilung (13), umfassend

   a) Bereitstellen einer Ablationsquelle, des Substrats (11) und eines Targets (1), das ein Targetmaterial umfasst, das inhomogen ist und auf dem Substrat (11) abgeschieden werden soll, wobei das inhomogene Target (1) mindestens zwei Segmente umfasst, wobei die Segmente unterschiedliche chemische Zusammensetzungen aufweisen,
   b) Emittieren eines Ablationsstrahls auf das Target (1) entlang einer Ablationsspur (3) mittels der Ablationsquelle derart, dass das Targetmaterial abgetragen und auf dem Substrat (11) unter Bildung der Dünnschichtmaterialzusammensetzung abgeschieden wird, wobei eine chemische Zusammensetzung eines Materialflusses (5) des Targetmaterials in Richtung des Substrats (11) durch eine durchschnittliche Zusammensetzung des Targetmaterials entlang der Ablationsspur (3) definiert ist

   **dadurch gekennzeichnet, dass**

   die Ablationsspur (3) die mindestens zwei Segmente wiederholt derart einbezieht, dass die Ablationsspur (3) die durchschnittliche chemische Zusammensetzung des Materialflusses (5) des Targetmaterials in Richtung des Substrats (11) definiert und
   eine Maske (7), die mindestens eine Öffnung (9) umfasst, die zwischen dem Target (1) und dem Substrat (11) angeordnet ist, wobei die Maske (7) und das Substrat (11) gegenwärtig bezüglich einander beweglich positioniert sind, was eine selektive Abscheidung der chemischen Zusammensetzung des Materialflusses (5) des Targetmaterials auf dem Substrat (11) ermöglicht, um die gewünschte Materialverteilung (13) zu ergeben.

2. Verfahren gemäß einem oder mehreren der vorhergehenden Ansprüche
   **dadurch gekennzeichnet, dass**
   eine Bewegung eines Ablationspunktes (2), um die Ablationsspur (3) zu definieren, durch Ablenken des Ablationsstrahls und/oder Bewegen des Targets (1), vorzugsweise durch Rotation des Targets (1), durchgeführt wird.

3. Verfahren gemäß einem oder mehreren der vorhergehenden Ansprüche
   **dadurch gekennzeichnet, dass**
   die mindestens zwei Segmente radial ausgerichtet sind und nicht der Rotationssymmetrie gehorchen und wobei die Ablationsspur (3) sich auf eine kreisförmige Bewegung des Auftreffpunkts des Ablationsstrahls auf dem Target (1) bezieht, die vorzugsweise aus einer Rotation des Targets (1) resultiert.

4. Verfahren gemäß einem oder mehreren der vorhergehenden Ansprüche
   **dadurch gekennzeichnet, dass**
   das Targetmaterial eine Legierung mit zwei oder mehr Legierungsbestandteilen, vorzugsweise eine Halbleiterlegierung, umfasst, und wobei das Target (1) mindestens zwei Segmente umfasst, wobei die Segmente chemische Zusammensetzungen aufweisen, die sich in der Zusammensetzung der zwei oder mehr Legierungsbestandteile unterscheiden.

5. Verfahren gemäß einem oder mehreren der vorhergehenden Ansprüche
   **dadurch gekennzeichnet, dass**
   die Ablationsquelle eine Sputterquelle, eine Elektronenstrahlquelle, eine Ionenstrahlquelle, vorzugsweise ein gepulster Laser ist.

6. Verfahren gemäß einem oder mehreren der vorhergehenden Ansprüche
   **dadurch gekennzeichnet, dass**
   die Materialverteilung (13) des Targetmaterials auf dem Substrat (11) einen lateralen Materialgradienten, einen vertikalen Materialgradienten, strukturierte Schichten und/oder einen dreidimensionalen Gradienten und/oder ein Muster in einem Schichtstapel umfasst.

**7.** Verfahren gemäß einem oder mehreren der vorhergehenden Ansprüche
**dadurch gekennzeichnet, dass**
die Materialverteilung (13) von Targetmaterial auf dem Substrat (11) einen lateralen und/oder vertikalen Materialgradienten umfasst, wobei der laterale und/oder vertikale Materialgradient eine Legierung, vorzugsweise eine Halbleiterlegierung, der allgemeinen Zusammensetzung $A_xB_{1-x}$ ist, wobei A und B jeweils Legierungsbestandteile identifizieren und x einen Anteil des Legierungsbestandteils A bezeichnet und zwischen 0 und 1 beträgt, wobei sich der Materialgradient hinsichtlich des Anteils des Legierungsbestandteils ändert, wobei sich vorzugsweise der Anteil mindestens eines Legierungspartners mit einem Gradienten von mindestens 3 %/mm, vorzugsweise mindestens 5 %/mm, insbesondere mindestens 10 %/mm ändert.

**8.** Verfahren gemäß einem oder mehreren der vorhergehenden Ansprüche
**dadurch gekennzeichnet, dass**
die Öffnung (9) einen Durchmesser zwischen 5 $\mu$m und 1000 $\mu$m, vorzugsweise zwischen 20 $\mu$m und 500 $\mu$m, mehr bevorzugt zwischen 50 $\mu$m und 200 $\mu$m aufweist.

**9.** Verfahren gemäß einem der vorhergehenden Ansprüche
**dadurch gekennzeichnet, dass**
die mindestens eine Öffnung (9) die Form eines Kreises, eines Schlitzes, eines Streifens, eines Dreiecks, eines Rechtecks, eines Quadrats oder einer beliebigen geometrischen Form aufweist.

**10.** Verfahren gemäß einem oder mehreren der vorhergehenden Ansprüche
**dadurch gekennzeichnet, dass**
die Maske (7) zwei oder mehr Öffnungen (9), vorzugsweise von gleichen Abmessungen und/oder in einer periodischen Anordnung derart umfasst, dass zwei oder mehr Materialverteilungen (13), vorzugsweise identische Materialverteilungen (13), gleichzeitig auf dem Substrat (11) gebildet werden können.

**11.** Verfahren gemäß einem oder mehreren der vorhergehenden Ansprüche
**dadurch gekennzeichnet, dass**
die Maske (7) und/oder das Substrat (11) bezüglich einander lateral beweglich sind, wobei eine laterale Bewegung der Maske (7) und/oder des Substrats (11) durch einen Aktuator bereitgestellt wird.

**12.** Verwendung eines Verfahrens zum Herstellen einer Dünnschichtmaterialzusammensetzung gemäß einem der vorhergehenden Ansprüche 1-11 zum Bereitstellen eines absorbierenden Elements, das zur Verwendung in einem Spektrometer oder Wellenmesser geeignet ist, einer p-n-Schicht, eines p-n-Schichtstapels, lichtemittierender Strukturen, eines Quantentopf-Infrarot-Photodetektors, plasmonischer Strukturen, eines Bragg-Reflektors, von Nanodrähten, einer supraleitenden Struktur und/oder eines Dünnschichttransistors.

**Revendications**

**1.** Procédé de production d'une composition de matériau en couches minces sur un substrat (11) avec une distribution de matériau souhaitée (13) consistant à

a) fournir une source d'ablation, le substrat (11) et une cible (1) comprenant un matériau cible qui n'est pas homogène et à déposer sur le substrat (11), la cible non homogène (1) comprenant au moins deux segments, les segments ayant des compositions chimiques différentes,
b) émettre un faisceau d'ablation sur la cible (1) le long d'une piste d'ablation (3) au moyen de la source d'ablation, de telle sorte que le matériau cible soit ablaté et déposé sur le substrat (11) formant la composition de matériau en couches minces, dans lequel une composition chimique d'un flux de matériau (5) de matériau cible vers le substrat (11) est définie par une composition moyenne de matériau cible le long de la piste d'ablation (3)

**caractérisé en ce que**

la piste d'ablation (3) recouvre de manière répétée lesdits au moins deux segments de telle sorte que la piste d'ablation (3) définit la composition chimique moyenne du flux de matériau (5) du matériau cible vers le substrat (11) et
un masque (7) comprenant au moins une ouverture (9) est situé entre la cible (1) et le substrat (11), dans lequel le masque (7) et le substrat (11) sont actuellement positionnés de manière mobile l'un par rapport à l'autre, permettant ainsi de déposer sélectivement la composition chimique du flux de matériau (5) du matériau cible sur le substrat (11) pour obtenir la distribution de matériau souhaitée (13).

2. Procédé selon l'une ou plusieurs des revendications précédentes
**caractérisé en ce que**
un déplacement d'un point d'ablation (2) pour définir la piste d'ablation (3) est effectué en déviant le faisceau d'ablation et/ou en déplaçant la cible (1), de préférence en faisant tourner la cible (1).

3. Procédé selon l'une ou plusieurs des revendications précédentes
**caractérisé en ce que**
les au moins deux segments sont alignés radialement et n'obéissent pas à une symétrie de rotation et dans lequel la piste d'ablation (3) consiste en un mouvement circulaire du point d'impact du faisceau d'ablation sur ladite cible (1), résultant de préférence d'une rotation de la cible (1).

4. Procédé selon l'une ou plusieurs des revendications précédentes
**caractérisé en ce que**
le matériau cible comprend un alliage comportant deux constituants d'alliage ou plus, de préférence un alliage semi-conducteur, et dans lequel la cible (1) comprend au moins deux segments, les segments ayant des compositions chimiques qui diffèrent dans la composition des deux constituants d'alliage ou plus.

5. Procédé selon l'une ou plusieurs des revendications précédentes
**caractérisé en ce que**
la source d'ablation est une source de pulvérisation cathodique, une source de faisceau d'électrons, une source de faisceau d'ions, de préférence un laser pulsé.

6. Procédé selon l'une ou plusieurs des revendications précédentes
**caractérisé en ce que**
la distribution de matériau (13) du matériau cible sur le substrat (11) comprend un gradient de matériau latéral, un gradient de matériau vertical, des couches à motifs et/ou un gradient et/ou motif tridimensionnel dans un empilement de couches.

7. Procédé selon l'une ou plusieurs des revendications précédentes
**caractérisé en ce que**
la distribution de matériau (13) du matériau cible sur le substrat (11) comprend un gradient de matériau latéral et/ou vertical, le gradient de matériau latéral et/ou vertical est un alliage, de préférence un alliage semi-conducteur, de composition générale $A_xB_{1-x}$, dans laquelle A et B identifient chacun des constituants de l'alliage et x désigne une proportion du constituant d'alliage A et est compris entre 0 et 1, dans lequel le gradient de matériau change en fonction de la proportion du constituant d'alliage, dans lequel de préférence la proportion d'au moins un partenaire d'alliage change avec un gradient d'au moins 3 % / mm, de préférence d'au moins 5 % / mm, en particulier d'au moins 10 % / mm.

8. Procédé selon l'une ou plusieurs des revendications précédentes
**caractérisé en ce que**
l'ouverture (9) a un diamètre compris entre 5 $\mu$m et 1 000 $\mu$m, de préférence entre 20 $\mu$m et 500 $\mu$m, de préférence encore entre 50 $\mu$m et 200 $\mu$m.

9. Procédé selon l'une ou plusieurs des revendications précédentes
**caractérisé en ce que**
l'au moins une ouverture (9) présente la forme d'un cercle, d'une fente, d'une bande, d'un triangle, d'un rectangle, d'un carré ou d'une forme géométrique arbitraire.

10. Procédé selon l'une ou plusieurs des revendications précédentes
**caractérisé en ce que**
le masque (7) comprend deux ouvertures (9) ou plus, de préférence de dimensions égales et/ou agencées périodiquement, de telle sorte que deux distributions de matériau (13) ou plus, de préférence des distributions de matériau identiques (13), peuvent être formées simultanément sur ledit substrat (11).

11. Procédé selon l'une ou plusieurs des revendications précédentes

**caractérisé en ce que**

le masque (7) et/ou le substrat (11) sont mobiles latéralement l'un par rapport à l'autre, dans lequel un mouvement latéral du masque (7) et/ou du substrat (11) est assuré par un actionneur.

12. Utilisation d'un procédé de production d'une composition de matériau en couches minces selon l'une quelconque des revendications 1 à 11 précédentes pour fournir un élément absorbant approprié pour être utilisé dans un spectromètre ou un ondemètre, une couche p-n, un empilement de couches p-n, des structures électroluminescentes, un photodétecteur infrarouge à puits quantique, des structures plasmoniques, un réflecteur de Bragg, des nanofils, une structure supraconductrice et/ou un transistor en couches minces.

Fig. 1

Fig. 2

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20120122317 A1
- US 20150030759 A1
- US 6045671 A

### Non-patent literature cited in the description

- **JILANI, ASIM et al.** Advance deposition techniques for thin film and coating.. *Modern Technologies for Creating the Thin-film Systems and Coatings*, 2017, vol. 2, 137-149
- **MILLER, N. CARL ; GEORGE A. SHIRN.** CO-SPUTTERED Au-SiO2 CERMET FILMS. *Applied Physics Letters*, 1967, vol. 10 (3), 86-88
- **SAKAI, JOE et al.** Control of Lateral Composition Distribution in Graded Films of Soluble Solid Systems A1-xBx by Partitioned Dual-Beam Pulsed Laser Deposition. *Coatings*, 2020, vol. 10 (6), 540
- **VON WENCKSTERN, HOLGER et al.** A Review of the Segmented-Target Approach to Combinatorial Material Synthesis by Pulsed-Laser Deposition. *physica status solidi*, 2020, vol. 257 (7), 1900626
- **VON WENCKSTERN, HOLGER et al.** Continuous composition spread using pulsed-laser deposition with a single segmented target.. *CrystEngComm*, 2013, vol. 15 (46), 10020-10027
- **KNEIß, MAX et al.** Combinatorial material science and strain engineering enabled by pulsed laser deposition using radially segmented targets. *ACS combinatorial science*, 2018, vol. 20 (11), 643-652